(19) **Europäisches Patentamt / European Patent Office / Office européen des brevets**

(11) **EP 3 306 820 A1**

(12) **EUROPEAN PATENT APPLICATION**

(43) Date of publication:
**11.04.2018 Bulletin 2018/15**

(51) Int Cl.:
*H03M 1/06* (2006.01)   *H04B 1/04* (2006.01)
*H04B 1/00* (2006.01)   *H03M 1/66* (2006.01)
*H03M 1/12* (2006.01)

(21) Application number: **16306319.1**

(22) Date of filing: **06.10.2016**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(71) Applicant: **ALCATEL LUCENT**
**92100 Boulogne-Billancourt (FR)**

(72) Inventor: **Xin, Yu**
**70435 Stuttgart (DE)**

(74) Representative: **2SPL Patentanwälte PartG mbB**
**Postfach 15 17 23**
**80050 München (DE)**

(54) **METHOD AND APPARATUS FOR CONVERTING A SIGNAL FROM ANALOG TO DIGITAL DOMAIN OR VICE VERSA**

(57) The present disclosure relates to methods and apparatuses for converting a signal from analog to digital domain or vice versa. An apparatus according to the present disclosure comprises signal provision circuitry (110) configured to provide a first and at least one second version of the signal, wherein the first and the second signal version differ by a predetermined phase difference; signal conversion circuitry (120) configured to convert the first and the at least one second signal version from analog to digital domain or vice versa to generate a first and at least one second converted signal version; phase rotation circuitry (130) configured to rotate a phase of at least one of the first and the second converted signal to generate a first and at least one second phase-rotated converted signal, wherein a difference of phase rotation between the first and the second converted signal corresponds to the predetermined phase difference; and signal combining circuitry (140) configured to combine the first and the at least one second phase-rotated converted signal

FIG. 1

EP 3 306 820 A1

## Description

The present disclosure generally relates to electronics and, more particularly, to methods and apparatuses for signal conversion between the analog and digital signal domain, or vice versa.

Background

An Analog-to-Digital Converter (ADC) is a system that converts an analog signal into a digital signal. A Digital-to-Analog Converter (DAC) performs the reverse function. In communication systems, the resolution of the DAC and the ADC can significantly affect the performance of a transceiver. The resolution of the converter indicates the number of discrete values it can produce over the range of analog values. The resolution determines the magnitude of the quantization error and therefore, beside the signal characteristic, determines the signal to noise ratio for an ideal ADC/DAC without the use of oversampling.

Conventionally, Delta Sigma Modulation (DSM) can be used to reshape the quantization noise and therefore improve the Signal-to-Noise Ratio (SNR) in certain frequency ranges of interests. However, DSM is based on a closed loop structure, which can raise high implementation efforts and costs. Another less relevant solution is dithering, which is used in Digital-to-Digital Converters (DDCs). DDCs are devices that convert one type of digital data to another type of digital data. For example, a DDC may consist of a sample rate or bit depth converter. This technique generally does not improve the SNR but eliminates some undesirable spectrum spurious.

Thus, there is a desire for improved quantization noise concepts.

Summary

According to a first aspect of the present disclosure, it is provided a method for converting a signal from analog to digital domain or vice versa. The method includes providing a first and at least one second version of the signal. The first and the second signal version differ by a predetermined phase difference. The first and the at least one second signal version are converted from analog to digital domain or vice versa to generate a first and at least one second converted signal version. A phase of at least one of the first and the second converted signal is rotated to generate a first and at least one second phase-rotated converted signal. A difference of phase rotation between the first and the second converted signal corresponds to the predetermined phase difference. The first and the at least one second phase-rotated converted signal are combined to generate a combined converted signal. In this way it is possible to reduce the effects of quantization error and thus to use DACs or ADCs with lower resolution.

According to a further aspect of the present disclosure, it is provided an apparatus for converting a signal from analog to digital domain or vice versa. The apparatus comprises signal provision circuitry configured to provide a first and at least one second version of the signal, wherein the first and the second signal version differ by a predetermined phase difference, signal conversion circuitry configured to convert the first and the at least one second signal version from analog to digital domain or vice versa to generate a first and at least one second converted signal version, phase rotation circuitry configured to rotate a phase of at least one of the first and the second converted signal to generate a first and at least one second phase-rotated converted signal, wherein a difference of phase rotation between the first and the second converted signal corresponds to the predetermined phase difference, and signal combining circuitry configured to combine the first and the at least one second phase-rotated converted signal.

According to yet a further aspect of the present disclosure, it is provided a transmitter. The transmitter comprises digital mixing circuitry configured to mix a digital baseband signal with digital carrier signal to generate a digital IF signal. A first and a subsequent second sample of the digital IF signal differ by a predetermined phase difference. The transmitter comprises a Digital-to-Analog Converter configured to convert the digital IF signal to the analog domain to generate an analog IF signal comprising an analog baseband signal component and an analog carrier signal component, analog mixing circuitry configured to mix the analog signal with the analog carrier signal component to obtain the analog baseband signal component, an analog delay network configured to generate a first and at least one second version of the analog baseband signal component, wherein the first and the at least one second version are delayed relative to each other, and signal combining circuitry configured to combine the first and the at least one second version of the analog baseband signal component.

Brief description of the Figures

Some embodiments of apparatuses and/or methods will be described in the following by way of example only, and with reference to the accompanying figures, in which

Fig. 1      schematically illustrates an example of an apparatus for converting a signal from analog to digital domain or vice versa;

Fig. 2      shows a flowchart of a method for converting a signal from analog to digital domain or vice versa;

Fig. 3A      shows a conventional ADC concept for a receiver;

Fig. 3B      shows an example of a proposed ADC concept for a receiver according to the present disclosure;

Fig. 3C    shows a further example of a proposed ADC concept for a receiver according to the present disclosure;

Fig.4A-C    illustrate the proposed concept in the In-phase (I) and Quadrature (Q) plane;

Fig. 5    illustrates simulation results for the concept of Fig. 3B;

Fig. 6A    shows a conventional DAC concept for a transmitter;

Fig. 6B    shows an example of a proposed DAC concept for a transmitter according to the present disclosure;

Fig. 6C    shows a further example of a proposed DAC concept for a transmitter according to the present disclosure;

Fig. 7A    shows a conventional ADC concept for a superheterodyne receiver;

Fig. 7B    shows an example of a proposed ADC concept for a superheterodyne receiver according to the present disclosure;

Fig. 8    illustrates simulation results for the concept of Fig. 7B;

Fig. 9A    shows a further conventional DAC concept for a transmitter;

Fig. 9B    shows a further example of a proposed DAC concept for a transmitter according to the present disclosure;

Fig. 10A    shows a block diagram of a communication system, where examples of the proposed concept can be employed; and

Fig. 10B    shows a block diagram of a direct conversion receiver, where examples of the proposed concept can be employed.

Description of Examples

Various examples will now be described more fully with reference to the accompanying drawings in which some examples are illustrated. In the figures, the thicknesses of lines, layers and/or regions may be exaggerated for clarity.

Accordingly, while examples are capable of various modifications and alternative forms, examples thereof are shown by way of example in the figures and will herein be described in detail. It should be understood, however, that there is no intent to limit examples to the particular forms disclosed, but on the contrary, examples are to cover all modifications, equivalents, and alternatives falling within the scope of the invention. Like numbers refer to like or similar elements throughout the description of the figures.

It will be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present. Other words used to describe the relationship between elements should be interpreted in a like fashion (e.g., "between" versus "directly between," "adjacent" versus "directly adjacent," etc.).

The terminology used herein is for the purpose of describing particular examples only and is not intended to be limiting. As used herein, the singular forms "a," "an" and "the" are intended to include the plural forms as well, unless the context clearly indicates otherwise. It will be further understood that the terms "comprises," "comprising," "includes" and/or "including," when used herein, specify the presence of stated features, integers, steps, operations, elements and/or components, but do not preclude the presence or addition of one or more other features, integers, steps, operations, elements, components and/or groups thereof.

Unless otherwise defined, all terms (including technical and scientific terms) used herein have the same meaning as commonly understood by one of ordinary skill in the art to which examples belong. It will be further understood that terms, e.g., those defined in commonly used dictionaries, should be interpreted as having a meaning that is consistent with their meaning in the context of the relevant art and will not be interpreted in an idealized or overly formal sense unless expressly so defined herein.

The following examples relate to analog-to-digital and/or digital-to-analog conversion, which can be applied in various fields of technology, such as audio or video signal processing as well as telecommunications. For example, analog-to-digital and/or digital-to-analog conversion can be used in various receiver or transmitter architectures. Hence, examples of the present disclosure may be useful for transceivers of wired or wireless communication systems.

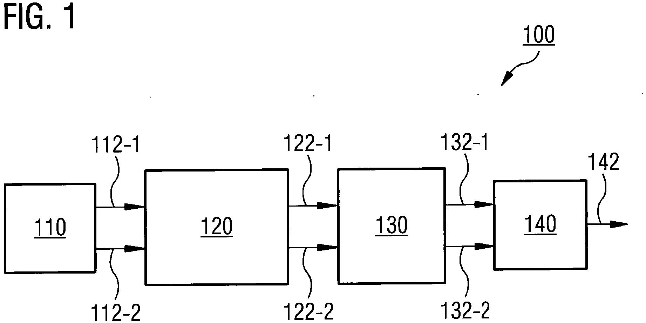

Turning now to FIG. 1, it is shown a schematic block diagram of an apparatus 100 for converting a signal from analog to digital domain or vice versa. Thus, signal conversion apparatus 100 can be used for Analog-to-Digital Conversion and/or Digital-to-Analog Conversion. The two signal domains, analog and digital, can also be more generally referred to as first and second signal domain, wherein the first signal domain can be analog or digital. Consequently, the second signal domain can be digital or analog.

Signal conversion apparatus 100 comprises signal provision circuitry 110 which is configured to provide a first version 112-1 and at least one second version 112-2 of the signal to be converted between the two signal domains. Signal provision circuitry 110 is configured to provide or generate the first and the second signal versions 112-1, 112-2 such that they differ by a predetermined phase difference. Thus, the different signal versions 112-1, 112-2 can also be understood as duplicates or copies of the same signal or data, however, each version 112-1, 112-2 having a different phase or phase offset. The skilled person having benefit from the present disclosure will appreciate that more than two signal versions or duplicates can be provided. Although FIG. 1 schematically illustrates the at least two signal versions 112-1, 112-2 provided in parallel, the skilled person will appreciate that the at least two signal versions 112-1, 112-2 could also well be provided serially.

The predetermined phase difference between signal versions 112-1, 112-2 can be provided or generated in various ways, as will be explained in more detail in the sequel. For example, the predetermined phase differences between the signal versions could be generated by active or passive phase shifting networks of signal provision circuitry 110. According to one example, a phase shifting network could comprise one or more delay lines to generate one or more phase shifted signal versions of the signal to be converted. In other examples, the signal to be converted could be provided as a Radio Frequency (RF) or Intermediate Frequency (IF) signal having an RF or IF carrier signal component carrying a useful baseband signal component. The skilled person having benefit from the present disclosure will appreciate that such an RF or IF signal inherently provides phase shifted versions of a baseband signal, given that the RF or IF carrier frequency is substantially higher than the bandwidth of the baseband signal (which is usually the case).

Signal conversion apparatus 100 further comprises signal conversion circuitry 120 which is configured to convert the first and the at least one second signal version 112-1, 112-2 from a first signal domain (analog/digital) to a second signal domain (digital/analog) to generate a first and at least one second converted signal version 122-1, 122-2. The skilled person having benefit from the present disclosure will appreciate that signal conversion circuitry 120 can comprise one or more corresponding signal converters, such as ADCs for analog-to-digital conversion and/or DACs for digital-to-analog conversion of the signal. Due to the limited resolution of signal conversion circuitry 120, the converted signal versions 122-1, 122-2 may each have quantization noise components. The quantization noise components are different among the different converted signal versions 122-1, 122-2, however.

Signal conversion apparatus 100 also comprises phase rotation circuitry 130 which is configured to rotate a phase of at least one of the first and the second converted signal versions 122-1, 122-2 to generate a first and at least one second phase-rotated converted signal 132-1, 132-2. Phase rotation circuitry 130 is configured to cause a difference in phase rotation between the first and the second converted signal which corresponds to their predetermined phase difference. In other words, phase rotation circuitry 130 is configured to de-rotate phases of the first and the at least one second converted signal versions 122-1, 122-2 to a common phase.

Signal combining circuitry 140 of apparatus 100 is configured to (coherently) combine the first and the at least one second phase-rotated (or de-rotated) converted signals 132-1, 132-2 to a combined signal 142, for example by (coherent) summation. In this way, the different quantization noise components of the signals 132-1, 132-2 can cancel each other out (at least in part), leading to an overall reduction of quantization noise. Thus, apparatus 100 can reach the quantization noise performance of an ADC or DAC with higher resolution, although employing ADCs or DACs of lower resolution.

In some examples, the signal to be converted comprises an In-phase (I) and Quadrature (Q) signal component. Said differently, the signal to be converted can be an analog or digital IQ signal.

In some examples, signal provision circuitry 110 can be configured to apply a predetermined phase shift to at least one of signal versions 112-1, 112-2 to generate at least one phase shifted signal version among the first and at least one second signal version 112-1, 112-2. The skilled person will appreciate that applying the at least one predetermined phase shift can be performed in the analog domain or in the digital signal domain by using conventional analog or digital phase shift modules. In the analog domain, a phase shift module is a network module which provides a controllable phase shift of a signal, such as an analog baseband, Intermediate Frequency (IF) or Radio Frequency (RF) signal. A simple example of a phase shift module would be a delay line. In the digital domain, phase shifts by $\Delta\phi$ can be implemented by multiplication of a signal by $e^{j\Delta\phi}$, for example.

In some examples, phase rotation circuitry 130 can be configured to apply the inverse predetermined phase shift to at least one phase shifted converted signal 122-1, 122-2 to generate at least one de-rotated converted signal. For example, if signal version 112-1 is not phase rotated (i.e., phase shift = 0°) and signal version 112-2 has been phase rotated by 30°, phase rotation circuitry 130 can be configured to rotate converted signal version 122-2 by -30° such that both de-rotated converted signal versions 132-1 and 132-2 have common phase. In another example, phase rotation circuitry 130 could be configured to rotate signal version 122-1 by -10° and signal version 122-2 by -(10°+30°)=-40° such that both de-rotated converted signal versions 132-1 and 132-2 have common phase, for example -10°. It is important that a difference in phase rotation between signals 122-1 and 122-2 corresponds to the predetermined phase difference of 30° in this example.

In some examples, signal conversion circuitry 120 can be configured to convert the first signal version with a first signal converter and to convert the at least one second signal version with at least one second signal converter. The first signal converter can be a first ADC (for Analog-to-Digital Conversion of the signal) or a first DAC (for Digital-to-Analog Conversion of the signal). The at least one second signal converter can be at least one second ADC (for Analog-to-Digital Conversion) or at least one second DAC (for Digital-to-Analog Conversion). Thus, signal conversion circuitry 120 can be configured to convert the first and the at least one second signal version 112-1, 112-2 in parallel using respective signal converters. The skilled person having benefit from the present disclosure will appreciate, however, that also a serial conversion of the first and the at least one second signal version 112-1, 112-2 is possible. The latter can be applied for converting an RF or IF signal, for example, as will be explained in more detail below.

In some examples, signal provision circuitry 110 can be configured to provide an analog signal having a baseband signal component modulated on an RF or IF carrier signal component. Due to the carrier signal component, the predetermined phase difference between the first and the second signal version 112-1, 112-2 is inherent to the analog signal. From a baseband signal perspective, adjacent signal portions merely differ by phase, given that the baseband signal bandwidth is considerably much lower than the carrier frequency such that the baseband signal component can be assumed to be substantially constant within one cycle (corresponding to a phase rotation of $2\pi$) of the carrier signal component. In such examples, signal conversion circuitry 120 can be configured to convert a portion of the analog signal corresponding to one cycle of the carrier signal component to the digital domain by generating a first digital signal sample of the analog signal at a first sampling instant within the cycle and by generating at least a second digital signal sample of the analog signal at at least a second sampling instant within the cycle. For example, if the analog signal is equidistantly sampled two times per cycle or period of the carrier signal component, the resulting samples will have a phase difference of 180°. If the analog signal is equidistantly sampled three times per cycle or period of the of the carrier signal component, the resulting samples will have a phase difference of 120°. Phase rotation circuitry 130 can be configured to rotate a phase of at least one of the first and the second digital signal sample in order to generate a first and at least one second de-rotated digital signal sample. Thereby a difference of phase rotation between the first and the second digital signal sample can correspond to a phase progression of the carrier signal component between the first and the second sampling instant (180° or 120° in the above examples). Signal combining circuitry 140 can be configured to combine (e.g., sum) the first and the at least one second de-rotated digital signal sample to obtain a combined digital signal.

In some examples, a frequency of the carrier signal component can be in the range from 50 to 200 MHz. That is, the analog signal to be analog-to-digital converted can be considered as an analog IF signal in some examples. The baseband signal bandwidth may be lower than 20 MHz, for example, such that a ratio between baseband signal bandwidth and the carrier frequency of the carrier signal component will be smaller than 0.5. Preferably, said ratio is even lower, e.g. 0.1.

In some examples, a duration of one cycle (corresponding to a phase shift of $2\pi$) of the carrier signal component is an integer multiple of a time difference between the first and second sampling time instants. In other words, the sampling frequency of the ADC can be an integer multiple of the carrier signal frequency. In this way, an integer number of digital signal samples can be provided per cycle of the carrier signal.

In some examples, the baseband signal component does not or at least not substantially change within the duration of one cycle of the carrier signal component. For example, a bandwidth of the baseband signal component can be less than ¼ of the carrier signal frequency or a sampling frequency used for generating successive digital signal samples.

In some examples, signal provision circuitry 110 can be configured to provide a digital signal having a digital baseband signal component modulated on a digital RF or IF carrier signal component. Due to the carrier signal component, the predetermined phase difference between the first and the second signal version 112-1, 112-2 is inherent to the digital signal. From a baseband signal perspective, adjacent signal samples merely differ by phase, given that the baseband signal bandwidth is considerably lower than the carrier frequency such that the baseband signal component can be assumed to be substantially constant within one cycle (corresponding to a phase rotation of $2\pi$) of the carrier signal component. Thus, a first and at least one subsequent or consecutive second sample of the digital signal differ by a predetermined phase difference. In such examples, signal conversion circuitry 120 can be configured to convert the digital signal to the analog signal domain in order to generate an analog RF or IF signal having an analog baseband signal component and an analog carrier signal component. Phase rotation circuitry 130 can be configured to mix the analog signal with the analog carrier signal component to obtain the analog baseband signal component. Here, phase de-rotation is performed by the mixing or down-conversion operation. An analog phase shift or delay network can be configured to generate a first and at least one second version of the analog baseband signal component, wherein the first and the at least one second version are phase shifted or delayed relative to each other. Signal combining circuitry can be configured to combine the first and the at least one second version of the analog baseband signal component.

Delays between the first and at least one second version of the analog baseband signal component can be relatively small, for example much smaller than a symbol period of the digital baseband signal component. In other words, a delay of at least one delayed signal version relative to an undelayed version of the analog baseband signal component can be less than $\frac{1}{5*B}$ or even less than $\frac{1}{10*B}$, wherein B denotes a bandwidth of the base-band signal component.

The skilled person having benefit from the present disclosure will appreciate that apparatus 100 can be useful as a signal conversion device in transceivers of communication devices. In particular for transmitters, apparatus 100 can further optionally include one or more mixers configured to mix the combined first and at least one second version of the analog baseband signal with an RF carrier signal.

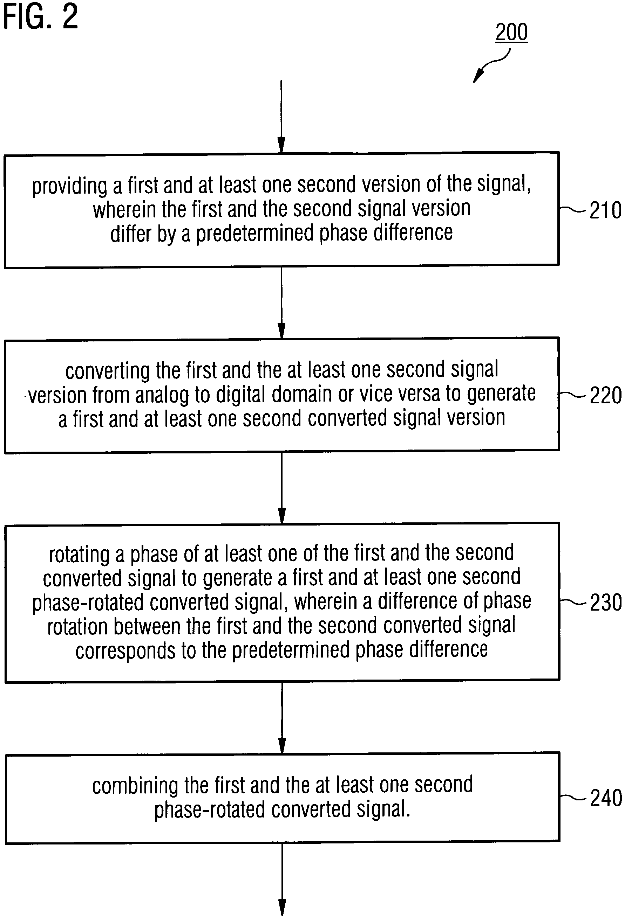

The skilled person having benefit from the present disclosure will appreciate that apparatus 100 can be used to perform a corresponding method for converting a signal from analog to digital domain or vice versa, a flow chart of which is sketched in FIG. 2.

Method 200 includes providing 210 a first and at least one second version of the signal to be converted. The first and the second signal version differ by a predetermined phase difference. The first and the at least one second signal version are converted 220 from analog to digital domain or vice versa to generate a first and at least one second converted signal version. A phase of at least one of the first and the second converted signal is rotated 230 to generate a first and at least one second phase-rotated converted signal. A difference of phase rotation between the first and the second converted signal corresponds to the predetermined phase difference. The first and the at least one second phase-rotated converted signal are combined 240 to generate a combined converted signal. In this way it is possible to reduce the effects of quantization error and thus to use DACs or ADCs with lower resolution.

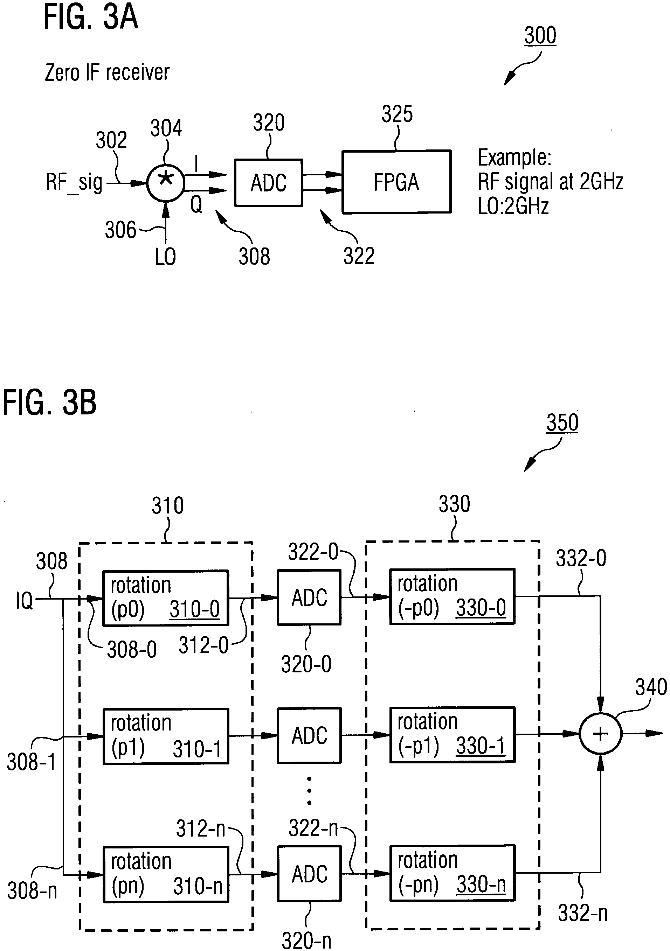

A first example of the present disclosure will now be explained with regard to FIGS 3A and 3B.

FIG. 3A shows a block diagram of a conventional direct conversion receiver 300. The skilled person having benefit from the present disclosure will appreciate that receiver 300 can include a various other hardware components, such as analog and/or digital filters, e.g. Band-Pass Filters (BPF), Low-Pass Filters (LPF), Low Noise Amplifies (LNAs), etc.

Receiver 300 receives an RF signal 302 which is directly down-converted to baseband domain using mixer 304, which is configured to mix RF signal 302 with a Local Oscillator (LO) signal 306. LO signal 306 is tuned to the carrier frequency of RF signal 302. At its output, mixer 304 provides analog baseband signal 308 having In-Phase component I and Quadrature component Q. Both components I and Q of baseband signal 308 are converted from analog to digital domain using ADC 320, which provides digital I and Q components of digital baseband signal 322. Digital baseband signal 322 is then further processed by digital baseband processor 325, which is implemented as Field Programmable Gate Array in the illustrated example. Other types of baseband processors could be used as well, such as Digital Signal Processors (DSPs) or Application Specific Integrated Circuits (ASICs). Depending on the resolution of ADC 320, the digital baseband signal 320 will suffer from more or less quantization noise. In general, the quantization noise will become smaller with increasing resolution or bit width of ADC 320 and vice versa. However, high resolution translates to high costs for ADC 320.

With the proposed example which is schematically illustrated in FIG. 3B, one or more ADCs of reduced resolution can be employed, while still keeping quantization noise low. In the receiver 350 of FIG. 3B, a plurality of $n+1$ duplications or versions 308-0 to 308-$n$ of analog baseband signal 308 with respective I- and Q-components are provided to phase rotator circuitry 310. Phase rotator circuitry 310 comprises $n+1$ phase rotators or phase shifters 310-0 to 310-$n$. In one example, phase rotators 310-0 to 310-$n$ can be implemented as respective analog phase modulators. However, other phase shifter implementations are of course also possible. Each of the phase rotators 310-0 to 310-$n$ is configured to rotate the phase of its respective complex-valued input signal version 308-0 to 308-$n$ by a respective predetermined phase rotation p0 to p$n$ to generate a respective phase shifted signal version 312-0 to 312-$n$. In general, the predetermined phase rotations p0 to p$n$ can be chosen arbitrarily. Preferably they should be mutually different from each other. A vanishing phase rotation p0 = 0° is of course also possible, for example. Given an original input phase $\phi_i$ of the analog baseband signal 308, the phases of phase shifted signal versions 312-0 to 312-$n$ at the output of phase rotator circuitry 310 can be assumed to be $\phi_i$+p0 to $\phi_i$+p$n$. The skilled person having benefit from the present disclosure will appreciate that the concept of FIG. 3B requires at least two duplications or versions of analog baseband signal 308 and that phase rotator circuitry 310 should be configured to apply a predetermined phase shift to at least one of those signal versions in order to generate at least one phase shifted signal version 312 among the first and at least one second signal version.

In the illustrated example, each of the phase shifted signal versions 312-0 to 312-$n$ is analog-to-digital converted using a respective ADC 320-0 to 320-$n$. The ADCs 320-0 to 320-$n$ output respective analog-to-digital converted signal versions 322-0 to 322-$n$. Although the analog-to-digital conversion of the $n+1$ signal versions is done in parallel in the illustrated example, the skilled person will appreciate that the analog-to-digital conversion of the $n+1$ signal versions could also be performed serially with moderate hardware modifications in alternative examples. In the latter case, only one ADC would be required.

In the illustrated example, each of the analog-to-digital converted and complex valued (IQ) signal versions 322-0 to 322-n is fed to a respective phase rotator 330-0 to 330-n of phase rotator circuitry 330. The phase rotators 330-0 to 330-n can also be thought of as phase de-rotators in the illustrated example since each of the phase rotators 330-0 to 330-n is configured to (de-)rotate the phase of its respective digital complex-valued input signal version 312-0 to 312-n by a respective predetermined phase rotation -p0 to -pn to generate a respective phase-rotated digital signal version 332-0 to 332-n. Note that a difference of phase (de-)rotation between a first and a second of the converted signals should correspond to their mutual predetermined phase difference. For example, if analog signal version 312-0 is not phase rotated (i.e., phase shift = 0°) and analog signal version 312-1 has been phase rotated by 30°, phase (de-)rotation circuitry 330 can be configured to rotate digital signal version 322-1 by -30° such that both de-rotated digital signal versions 332-0 and 332-1 have common phase again. In another example, phase (de-)rotation circuitry 330 could be configured to rotate digital signal version 322-0 by -10° and digital signal version 322-1 by -(10°+30°)=-40° such that both de-rotated digital signal versions 332-0 and 332-1 have common phase -10°. It is important that a difference in phase rotation between signals 322-0 and 322-1 corresponds to the predetermined phase difference of 30° in this example. Of course, this principle holds for other signal pairs as well.

After phase de-rotation, the de-rotated digital signal versions 332-0 to 332-n are summed up by signal combiner 340 to get a combined digital signal which can further be fed to digital baseband processor 325, for example.

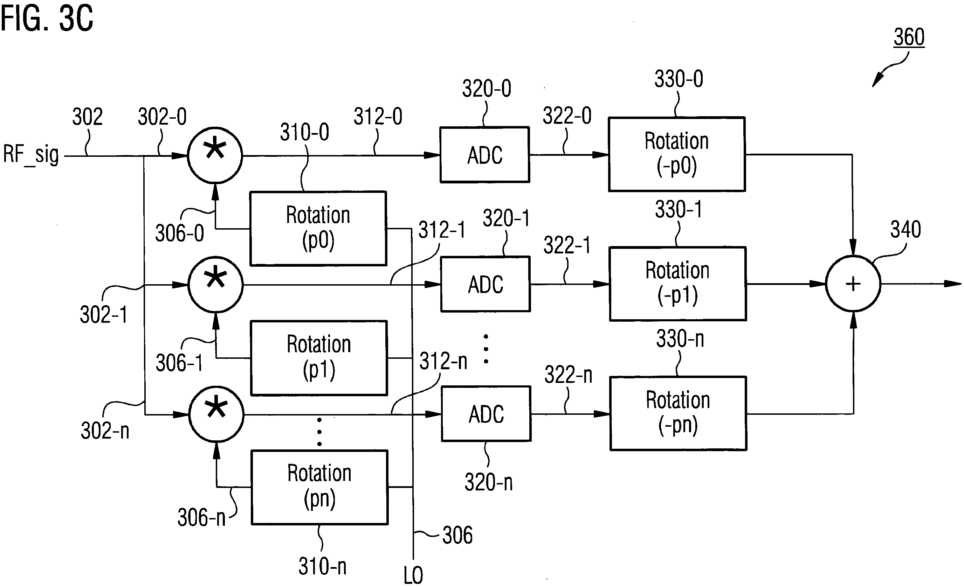

Another possible implementation of a direct conversion receiver 360 is schematically illustrated in FIG. 3C. Here, phase rotated analog baseband signals 312-0 to 312-n are provided by down-converting different versions 302-0 to 302-n of RF signal 302 with phase-shifted versions 306-0 to 306-n of LO signal 306. That is to say, the phase shifts are applied in the RF domain. In one example, the phase rotators or shifters 310-0 to 310-n can be implemented as delay lines. Each of the phase rotators 310-0 to 310-n is configured to rotate the phase of its respective complex-valued LO signal duplicate by a respective predetermined phase rotation p0 to pn to generate a respective phase shifted LO signal version 306-0 to 306-n. The LO signal versions 306-0 to 306-n are then mixed with respective versions 302-0 to 302-n of RF signal 302 to generate respective phase shifted analog baseband signal versions 312-0 to 312-n. Like in the example of FIG 3B, each of the phase shifted signal versions 312-0 to 312-n is analog-to-digital converted using a respective ADC 320-0 to 320-n. Like in the example of FIG 3B, each of the analog-to-digital converted and complex valued (IQ) signal versions 322-0 to 322-n is fed to a respective phase rotator 330-0 to 330-n of phase (de-)rotator circuitry 330. After phase de-rotation, the de-rotated digital signal versions 332-0 to 332-n are summed up by signal combiner 340 to get a combined digital signal which can further be fed to digital baseband processor 325, for example.

In FIG. 3B, the received analog IQ data is at first duplicated and individually rotated by phase p0 to pn, the quantized IQ samples after ADC are shifted back in digital domain. Finally, all IQ samples are summed up.

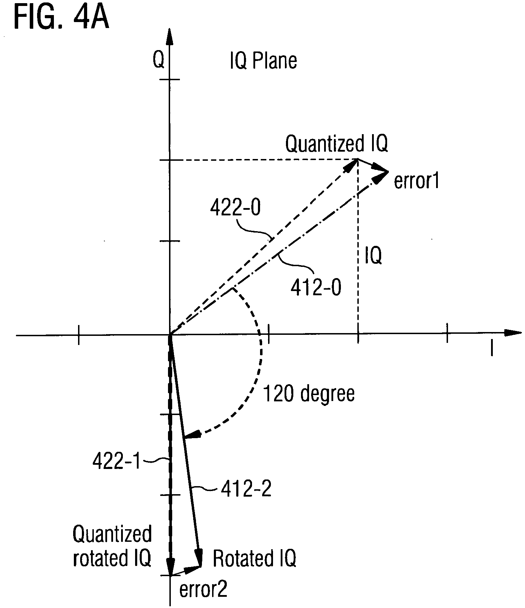

An illustrative example with two signal versions will now be explained with reference to FIGS. 4A to 4C.

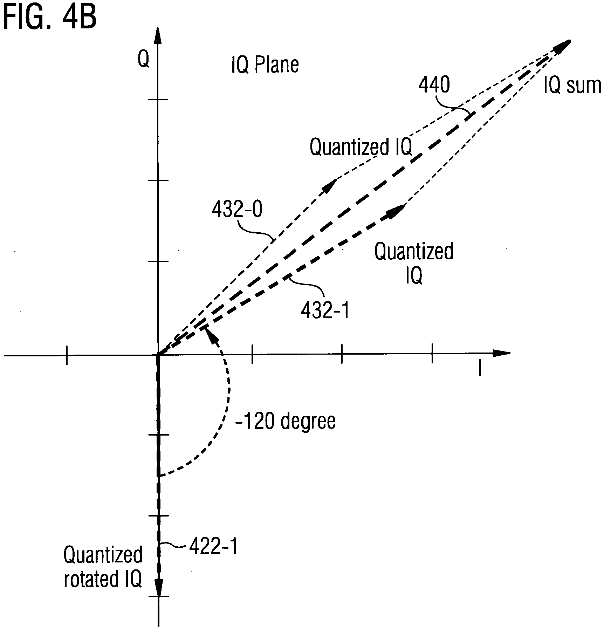

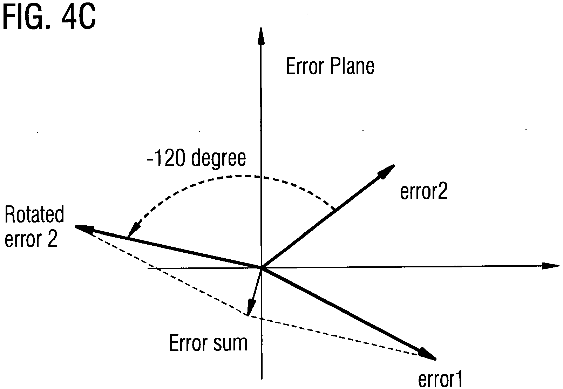

At first, the input data 308 can be interpolated by zero order hold principle. In FIG. 4A, the arrows 412-0 and 412-1 represent an IQ sample and its rotated version of 120°, respectively. The dotted arrows 422-0 and 422-1 depict the quantized IQ samples 322-0 and 322-1 according to the quantization grid on I and Q axis in the IQ plane. Subsequently, we shift dotted quantized IQ sample 422-2 by -120 degree back to the initial position. The sum of the two quantized IQ samples 432-0 and 432-1 is the final quantized signal, as shown in FIG. 4B. Fortunately, in the error plane of FIG. 4C, the error2 after rotation of -120 degree has almost 180° phase shift to the error1. Consequently, the sum of these two errors becomes much smaller and hence higher Signal-to-Noise Ratio (SNR) can be achieved.

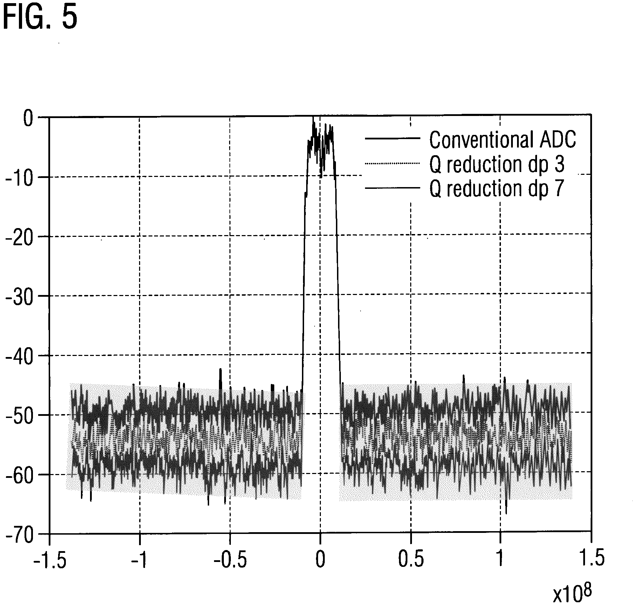

FIG. 5 shows simulation results for different numbers of duplicated signal versions (duplication factors). In the simulation, the ADCs 310 for I and Q have 6 bits resolution. A 5MHz Long-Term Evolution (LTE) signal was used as input signal 308 to stimulate the structure depicted in FIG. 3B. Depending on the number of duplications, we obtain about 5dB and 10dB SNR improvement over the conventional setup of FIG. 3A for the duplication factors of 3 and 7, respectively. It is noted, that the absolute phases of each rotation module are not critical, as long as the relative phases between p0 to pn and -p0 to - pn are same.

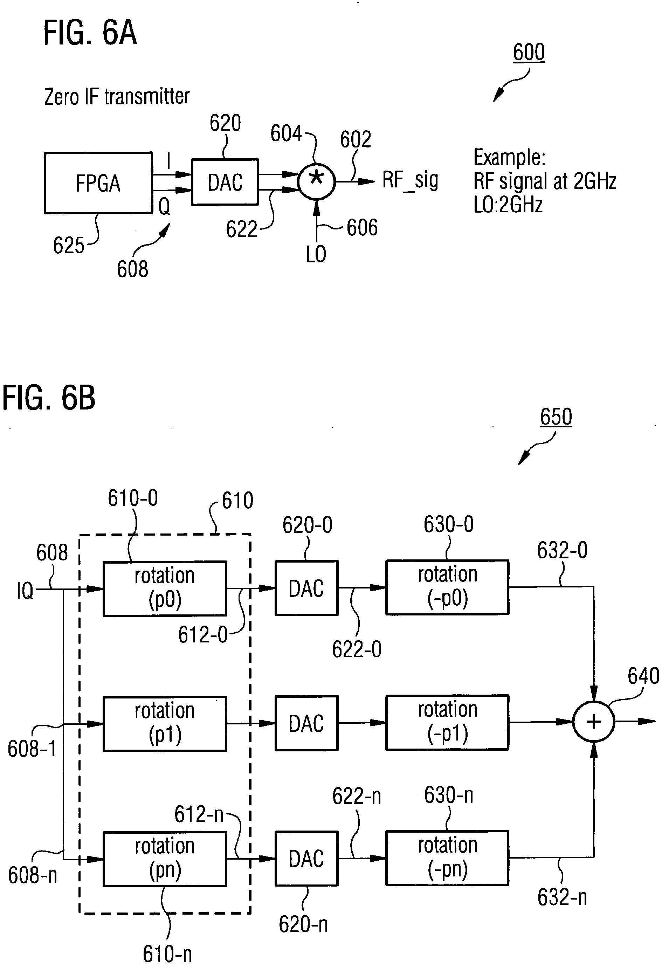

Another example of the present disclosure will now be explained with regard to FIGS 6A and 6B.

FIG. 6A shows a block diagram of a conventional transmitter 600. The skilled person having benefit from the present disclosure will appreciate that transmitter 600 can include various other hardware components, such as analog and/or digital filters, e.g. Band-Pass Filters (BPF), Low-Pass Filters (LPF), Power Amplifies (PAs), etc.

A digital baseband processor 625 generates a digital baseband signal 608 having In-Phase component I and Quadrature component Q. Both components I and Q of digital baseband signal 608 are converted from digital to analog domain using DAC 620, which provides analog I and Q components of analog baseband signal 622. Analog baseband signal 622 is then up-converted to RF domain using mixer 604, which is configured to mix baseband signal 622 with a Local Oscillator (LO) signal 306. LO signal 306 is tuned to the carrier frequency of RF signal 602. At its output, mixer 604 provides analog RF signal. Depending on the resolution of DAC 620, the analog baseband signal 622 will suffer from more or less DAC conversion noise. In general, the noise will become smaller with increasing resolution or bit width of DAC 320 and vice versa. However, high resolution translates to high costs for DAC 620.

With the proposed example which is schematically illustrated in FIG. 6B, one or more DACs of reduced resolution can be employed. At the same time, the conversion noise can be kept low. In the transmitter 650 of FIG. 6B, a plurality of $n+1$ duplications or versions 608-0 to 608-$n$ of digital baseband signal 608 with respective I- and Q-components are provided to phase rotator circuitry 610. Phase rotator circuitry 610 comprises $n+1$ phase rotators or phase shifters 610-0 to 610-$n$. In one example, phase rotators 610-0 to 610-$n$ could be implemented as respective multipliers for multiplying the signal versions with $e^{jp0}$, $e^{jp1}$, ..., $e^{jpn}$. However, other digital phase shifter implementations are of course also possible. Each of the phase rotators 610-0 to 610-$n$ is configured to rotate the phase of its respective complex-valued input signal version 608-0 to 608-$n$ by a respective predetermined phase rotation p0 to p$n$ to generate a respective phase shifted signal version 612-0 to 612-$n$. In general, the predetermined phase rotations p0 to p$n$ can be chosen arbitrarily. Preferably they should be mutually different from each other. Given an original input phase $\phi_i$ of the digital baseband signal 608, the phases of phase shifted signal versions 612-0 to 612-$n$ at the output of phase rotator circuitry 610 can be assumed to be $\phi_i+p0$ to $\phi_i+p n$. The skilled person having benefit from the present disclosure will appreciate that the concept of FIG. 6B requires at least two duplications or versions of the digital baseband signal and that phase rotator circuitry 610 should be configured to apply a predetermined phase shift to at least one of those signal versions in order to generate at least one phase shifted signal version among the first and at least one second signal version.

In the illustrated example, each of the phase-shifted digital signal versions 612-0 to 612-$n$ is digital-to-analog converted using a respective DAC 620-0 to 620-$n$. The DACs 620-0 to 620-$n$ output respective digital-to-analog converted signal versions 622-0 to 622-$n$. Although the digital-to-analog conversion of the $n+1$ signal versions is done in parallel in the illustrated example, the skilled person will appreciate that the digital-to-analog conversion of the $n+1$ signal versions could also be performed serially with moderate hardware modifications in alternative examples. In the latter case, only one DAC would be required.

In the illustrated example, each of the digital-to-analog converted and complex valued (IQ) signal versions 622-0 to 622-$n$ is fed to a respective phase rotator 630-0 to 630-$n$ of phase rotator circuitry 630. The phase rotators 630-0 to 630-$n$ can also be thought of as phase de-rotators in the illustrated example since each of the phase rotators 630-0 to 630-$n$ is configured to (de-)rotate the phase of its respective analog complex-valued input signal version 612-0 to 612-$n$ by a respective predetermined phase rotation -p0 to -p$n$ to generate a respective phase-rotated analog signal version 632-0 to 632-$n$. Note that a difference of phase (de-)rotation between a first and a second of the converted signals should corresponds to their mutual predetermined phase difference. For example, if digital signal version 612-0 is not phase rotated (i.e., phase shift = 0°) and digital signal version 612-1 has been phase rotated by 30°, phase (de-)rotation circuitry 630 can be configured to rotate analog signal version 622-1 by -30° such that both de-rotated analog signal versions 632-0 and 632-1 have common phase again. In another example, phase (de-)rotation circuitry 630 could be configured to rotate analog signal version 622-0 by - 10° and analog signal version 622-1 by -(10°+30°)=-40° such that both de-rotated analog signal versions 632-0 and 632-1 have common phase -10°. It is important that a difference in phase rotation between signals 622-0 and 622-1 corresponds to the predetermined phase difference of 30° in this example. Of course, this principle holds for other signal pairs as well.

After phase de-rotation, the de-rotated digital signal versions 632-0 to 632-n are summed up by adder 640 to get a combined digital signal which can further be fed to mixer 604, for example.

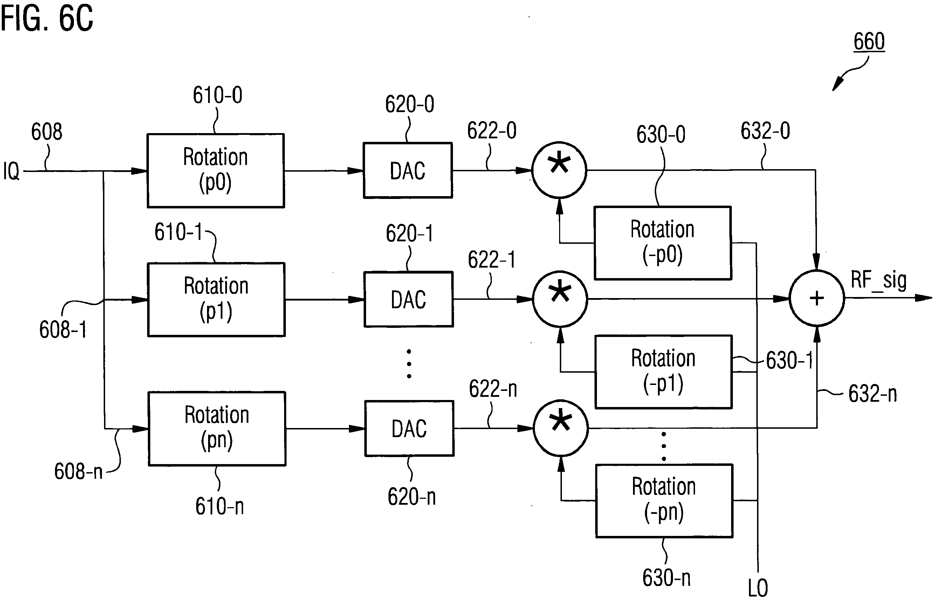

A possible implementation of a direct conversion transmitter 660 is schematically illustrated in FIG. 6C. Here, phase (de-)rotated analog RF signals 632-0 to 632-$n$ are provided by up-converting each of the digital-to-analog converted and complex valued (IQ) baseband signal versions 622-0 to 622-$n$ with respective phase-shifted versions 606-0 to 606-$n$ of LO signal 606. That is to say, the phase shifts are applied in the RF domain. In one example, the phase rotators or shifters 630-0 to 630-$n$ can be implemented as delay lines. Each of the phase (de-)rotators 630-0 to 630-$n$ is configured to rotate the phase of the LO signal 606 by a respective predetermined phase rotation -p0 to -p$n$ to generate a respective phase shifted LO signal version 606-0 to 606-$n$. The LO signal versions 606-0 to 606-$n$ are then mixed with respective digital-to-analog converted signal versions 622-0 to 622-$n$ that are (coherently) summed up by signal combiner 640 to get a combined analog RF signal.

In FIG. 6B, the digital IQ data is at first duplicated and individually rotated by phase p0 to pn, the digital-to-analog converted IQ signals after DAC are shifted back in analog domain. Finally, all analog IQ signal versions are summed up.

The structure of proposed approach in DAC side is quite similar to the case of ADC. One just replaces the ADCs by DACs, the rotations in first column and the last column are done in digital and analogue domain. In simulation we almost get the same picture as for ADC.

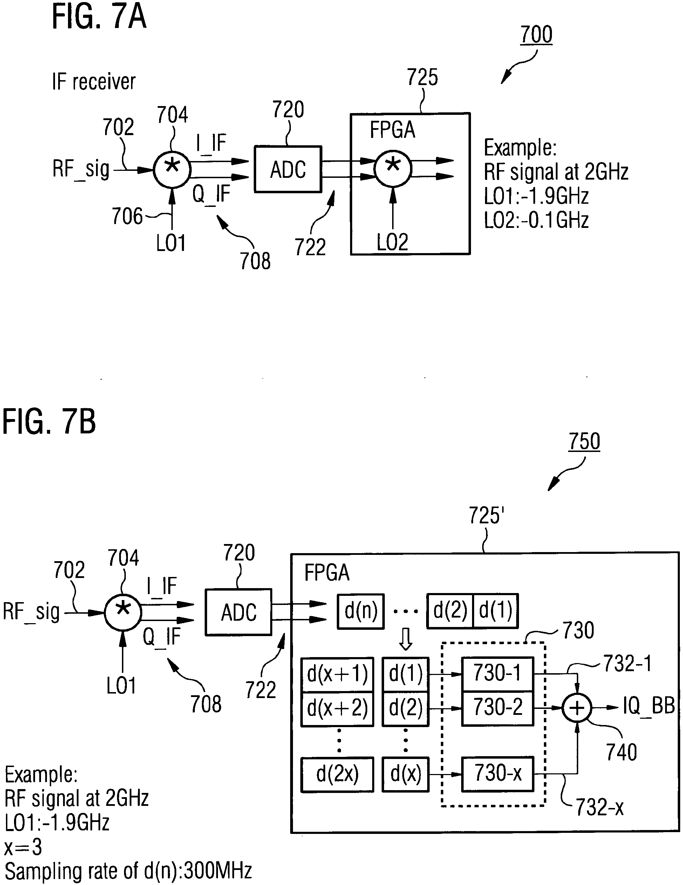

A further example of the present disclosure will now be explained with regard to FIGS 7A and 7B.

FIG. 7A shows a simplified block diagram of a conventional superheterodyne receiver 700. The skilled person having benefit from the present disclosure will appreciate that receiver 700 can include various other hardware components, such as analog and/or digital filters, e.g. Band-Pass Filters (BPF), Low-Pass Filters (LPF), Low Noise Amplifies (LNAs), etc.

Receiver 700 receives an RF signal 702 which is down-converted baseband in several steps, passing via one or more of IF stages each with its own local oscillator (LO). In the illustrated example, RF signal 702 is down-converted to intermediate frequency domain using mixer 704, which is configured to mix RF signal 702 with a first Local Oscillator (LO1) signal 706. First LO signal 706 is tuned to a frequency between zero and the carrier frequency of RF signal 302. In the illustrated example, the LO frequency is 1.9 GHz, while the RF frequency is 2 GHz. At its output, mixer 704 provides analog IF signal 708 having In-Phase component I and Quadrature component Q. For example, a carrier frequency of the IF signal 708 can be in the range from 50 to 200 MHz. In the illustrated example, the carrier frequency of the IF signal 708 is 100 MHz. Both components I and Q of IF signal 708 are converted from analog to digital domain using ADC 720, which provides digital I and Q components of digital IF signal 722. Digital IF signal 722 is then down-converted to digital baseband domain and further processed by digital processor 725, which is implemented as Field Programmable Gate Array in the illustrated example. Depending on the resolution of ADC 720, the digital IF signal 722 will suffer from more or less quantization noise. In general, the quantization noise will become smaller with increasing resolution or bit width of ADC 720 and vice versa.

With the proposed example illustrated in FIG. 7B, the quantization noise can be reduced. The receiver 750 of FIG. 7B differs from the structure of FIG. 7A in the digital processor 725'. ADC 720 provides digital IF signal 722 having a carrier signal component and a baseband signal component modulated thereon. If the bandwidth of the baseband signal component is assumed to be considerably smaller than the frequency of the carrier signal component then adjacent samples of the digital IF signal 722 will differ by a predetermined phase difference corresponding to the phase progression of the carrier signal component between the adjacent sampling instants. In other words, the ADC 720 inherently provides phase shifted versions of the baseband signal component. Subsequent samples of digital IF signal 722 differ by a predetermined phase difference defined by the phase progression of the carrier signal component between adjacent sampling instants.

Digital processor 725' receives samples d(1), ..., d(n) of digital IF signal 722. In FIG. 7B it is assumed that ADC 720 outputs x samples per cycle or period of carrier signal component, x being a positive integer number. In the illustrated example x=3. That is, ADC 720 generates three samples of IQ data within one cycle or period of carrier signal component. In other words, the sampling rate of ADC 720 is three times (x-times) higher than the IF carrier signal frequency.

Digital processor 725' comprises phase rotator circuitry 730 including x phase rotators 730-1 to 730-x. x consecutive complex valued (IQ) signal versions 722-1 to 722-x spanning one cycle or period of carrier signal component are fed to respective phase rotators 730-1 to 730-x. The phase rotators 730-1 to 730-x can also be thought of as phase de-rotators in the illustrated example since each of the phase rotators 730-1 to 730-x is configured to (de-)rotate the phase of its respective digital complex-valued input signal version 722-1 to 722-x by a respective predetermined phase rotation -p0 to -px to generate a respective phase-rotated digital signal version 732-0 to 732-x. Note that a difference of phase rotation between adjacent digital signal samples 722-1 and 722-2 or 722-(x-1) and 722-x corresponds to the phase progression of the carrier signal component between the respective adjacent sampling instants. With three sampling instants per cycle or period of the carrier signal component, the difference of phase (de-)rotation between adjacent digital signal samples corresponds to 120°. With six sampling instants per cycle or period of the carrier signal component, the difference of phase (de-)rotation between adjacent digital signal samples 722-1 and 722-2 or 722-(x-1) and 722-x would correspond to 60°, for example.

After phase de-rotation, the de-rotated digital signal versions 732-0 to 732-x are summed up by signal combiner 740 to get a combined digital signal IQ_BB. Note that signal IQ_BB is a complex valued digital baseband signal. Thus, the skilled person having benefit from the present disclosure will appreciate that digital processor 725' performs a down-conversion of signal 722 from IF-domain to baseband domain.

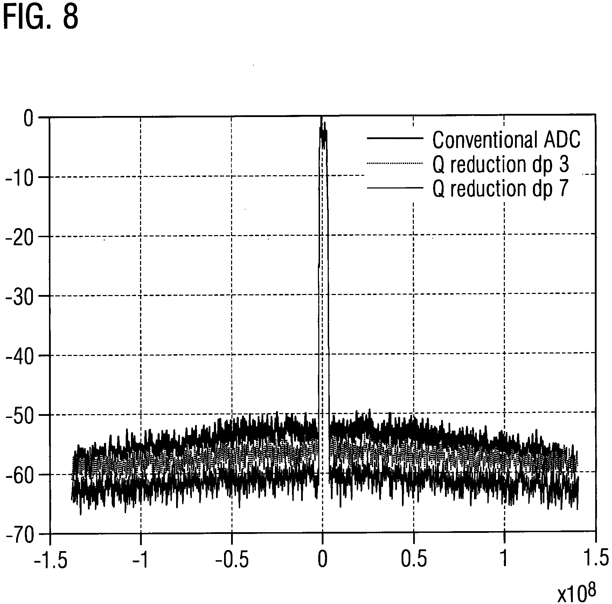

Thus, if the signal bandwidth is much lower in comparison to ADC bandwidth, one can even simplify the receiver structure proposed in FIG. 3B to the one shown in FIG. 7B with only one ADC. In case of strong over sampling rate we can assume that the successive IQ samples are almost same. The input IQ signal is modulated at an IF and the phase shifts from p0 to pn are advantageously evenly distributed from 0 to 360 degree. The simulation result with the same setting of FIG. 3B but 1.4MHz LTE signal is presented in FIG. 8. We can observe similar SNR improvement of 5dB to 10 dB.

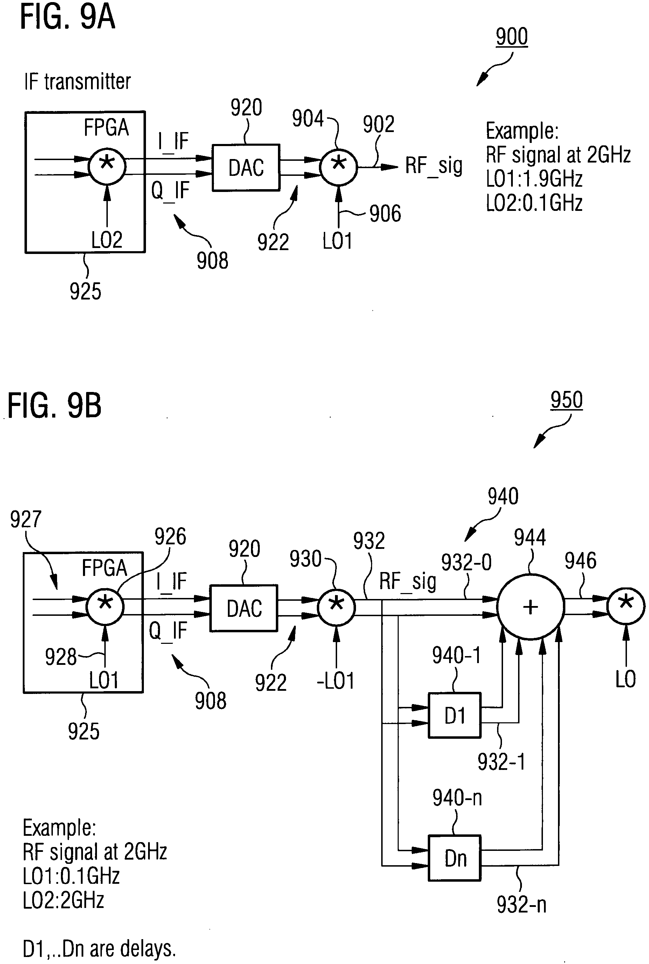

A further example of the present disclosure will now be explained with regard to FIGS 9A and 9B.

FIG. 9A shows a simplified block diagram of a conventional transmitter 900. The skilled person having benefit from the present disclosure will appreciate that transmitter 900 can include various other hardware components, such as analog and/or digital filters, , e.g. Band-Pass Filters (BPF), Low-Pass Filters (LPF), Power Amplifies (PAs), etc.

A digital baseband processor 925 generates a digital IF signal 908 having In-Phase component I and Quadrature component Q. For example, a carrier frequency of the IF signal 908 can be in the range from 50 to 200 MHz. In the illustrated example, the carrier frequency of the IF signal 908 is 100 MHz. Both components I and Q of digital IF signal 908 are converted from digital to analog domain using DAC 920, which provides analog I and Q components of analog IF signal 922. Analog IF signal 922 is then further up-converted to RF domain using mixer 904, which is configured to mix IF signal 922 with a Local Oscillator (LO) signal 906. LO signal 906 is tuned to a frequency between zero and the carrier frequency of RF signal 902. In the illustrated example, the LO frequency is 1.9 GHz, while the RF frequency is 2 GHz. At its output, mixer 904 provides analog RF signal. Depending on the resolution of DAC 920, the analog IF signal 922 will suffer from more or less DAC conversion noise. In general, the noise will become smaller with increasing resolution or bit width of DAC 920 and vice versa.

With the proposed example illustrated in FIG. 9B, a DAC 920 of reduced resolution can be employed. At the same time, the conversion noise can be kept low. The transmitter 950 of FIG. 9B differs from the structure of FIG. 9A in its analog circuit portion. Digital baseband processor 925 comprises digital mixing circuitry 926 configured to mix a digital baseband signal 927 with a digital carrier signal 928 to generate digital IF signal 908. As has been explained before, subsequent samples of digital IF signal 908 differ by a predetermined phase difference corresponding to a phase progression between consecutive samples of the IF carrier signal 928, given that the digital baseband signal remains constant between the consecutive samples of the digital IF carrier signal 928 (if the bandwidth of the baseband signal component is assumed to be considerably smaller than the frequency of the carrier signal component). DAC 920 provides analog IF signal 922 having a carrier signal component and a baseband signal component modulated thereon. Thus, analog IF signal portions corresponding to adjacent digital IF signal samples will differ by a predetermined phase difference corresponding to the phase progression of the IF carrier signal component between the adjacent sampling instants. In the illustrated example, transmitter 950 comprises analog mixing circuitry 930 configured to mix the analog IF signal 922 with the analog IF carrier signal 938 to obtain an analog IQ baseband signal 932. Analog mixing circuitry 930 is configured to perform down-conversion from IF domain to baseband domain, thus the inverse operation to digital up-conversion from baseband to IF in digital processor 925. That is to say, while the digital up-conversion from baseband to IF can be considered as the provision of differently phase rotated versions of the baseband signal, the analog down-conversion from IF to baseband can be considered as the inverse phase rotation.

Downstream to mixer 930 transmitter 950 comprises an analog delay network 940 which is configured to generate a plurality of versions or copies 932-0 to 932-n of the analog baseband signal 932. A first and a second of the plurality of versions 932-0 to 932-n of the analog baseband signal 932 are phase shifted or delayed relative to each other. This can be done using a phase shifter network or, as in the illustrated example, using a plurality of delay lines 940-1 to 940-n. The plurality of delayed baseband signal versions 932-0 to 932-n is then combined using signal combining circuitry 944 before the combined baseband signal 946 is up-converted to RF domain. A frequency of the analog RF carrier signal is larger, for example more than ten times larger, than a frequency of the digital carrier signal 928.

Note that the respective delays D1 to Dn of delay lines 940-1 to 940-n can be relatively small, for example much smaller than a symbol period $T_S$ of the digital baseband signal component 927. A delay D1 to Dn of a delayed signal version relative to the undelayed version of the analog baseband signal component 932 can be less than $\dfrac{1}{5*B}$ or even less than $\dfrac{1}{10*B}$, wherein $B$ denotes a bandwidth of the baseband signal component 927. Said differently, the delays D1 to Dn can be smaller than $\dfrac{1}{5}T_S$ or even smaller than $\dfrac{1}{10}T_S$. In this way, the quantization noise components of the differently delayed baseband signals 932-0 to 932-n can statistically cancel each other out, leading to an improved SNR of combined signal 946.

As has been mentioned before, the concepts proposed in the present disclosure can be useful for analog-to-digital and/or digital-to-analog conversion in receivers or transmitters of wired or wireless communication systems.

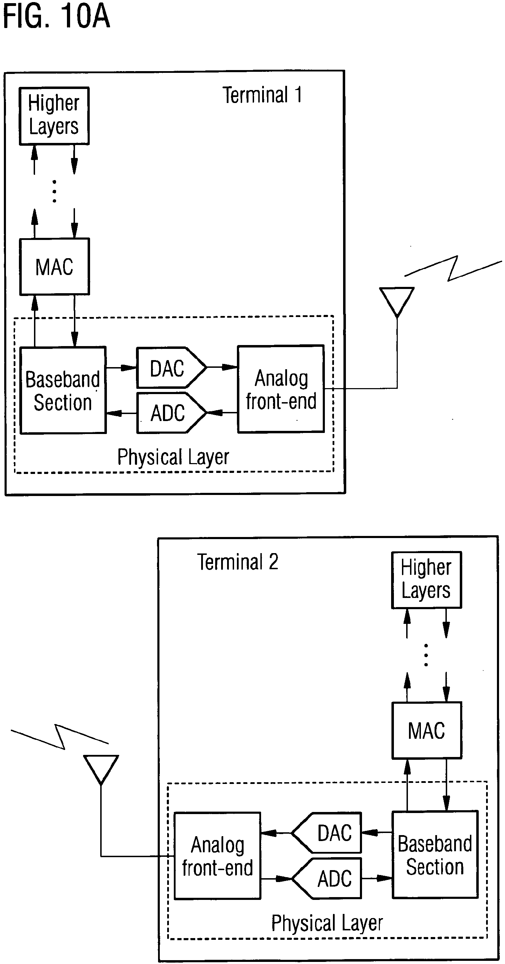

FIG. 10A shows two terminals Terminal 1 and Terminal 2 of a wireless communication system which may correspond to, for example, a Long-Term Evolution (LTE), an LTE-Advanced (LTE-A), High Speed Packet Access (HSPA), a Universal Mobile Telecommunication System (UMTS) or a UMTS Terrestrial Radio Access Network (UTRAN), an evolved-UTRAN (e-UTRAN), a Global System for Mobile communication (GSM) or Enhanced Data rates for GSM Evolution (EDGE) network, a GSM/EDGE Radio Access Network (GERAN), or mobile communication networks with different standards, for example, a Worldwide Inter-operability for Microwave Access (WIMAX) network IEEE 802.16 or Wireless Local Area Network (WLAN) IEEE 802.11, generally an Orthogonal Frequency Division Multiple Access (OFDMA) network, a Time Division Multiple Access (TDMA) network, a Code Division Multiple Access (CDMA) network, a Wide-band-CDMA (WCDMA) network, a Frequency Division Multiple Access (FDMA) network, a Spatial Division Multiple Access (SDMA) network, etc.

Terminal 1 and Terminal 2 communicate over a wireless channel and both comprise hard- and software components related to the physical layer as well as higher network layers. As can be seen, there is a digital-to-analog and analog-to-digital conversion between the respective baseband modules and analog transceiver front-ends. The skilled person having benefit from the present disclosure will appreciate that digital-to-analog and analog-to-digital conversion modules described in the present disclosure can replace conventional digital-to-analog and analog-to-digital conversion modules.

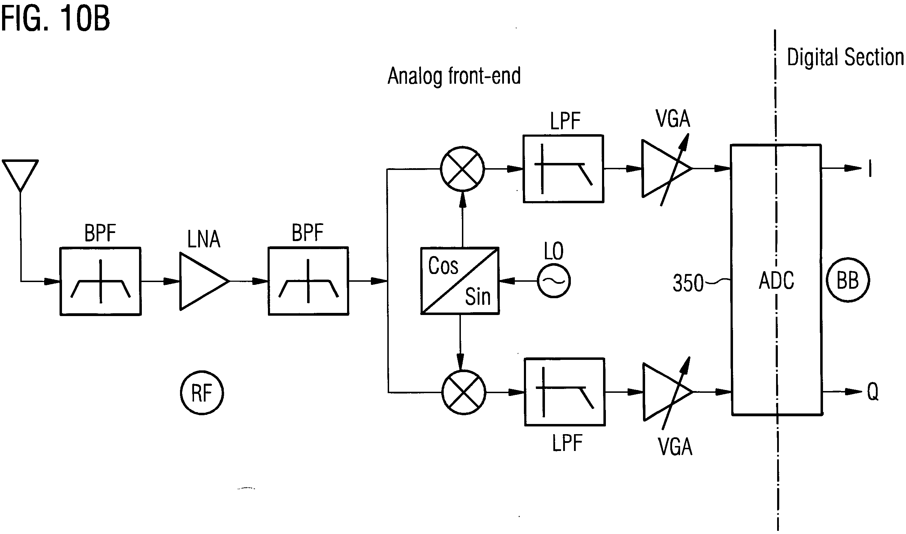

**FIG. 10B** shows a block diagram of a direct conversion receiver architecture, where an analog baseband IQ signal can be analog-to-digital converted according to the present disclosure, for example according to the principle explained with reference to FIG. 3B.

In this disclosure, a novel approach is proposed to reduce quantization error. In this way one is able to use DACs or ADCs with low resolution for cost reduction purpose. The proposed concept can yield additional 5dB to 10dB better SNR with reasonable increased hardware resources. The higher the duplication factor, the better the performance. For narrow band applications, this approach becomes feasible without duplication (additional hardare resources) for ADC concept.

The description and drawings merely illustrate the principles of the invention. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and examples of the invention, as well as specific examples thereof, are intended to encompass equivalents thereof.

Functional blocks shall be understood as functional blocks comprising circuitry that is adapted for performing a certain function, respectively. Hence, a "means for s.th." may as well be understood as a "means being adapted or suited for s.th.". A means being adapted for performing a certain function does, hence, not imply that such means necessarily is performing said function (at a given time instant).

Functions of various elements shown in the figures, including any functional blocks may be provided through the use of dedicated hardware, such as "a processor", "a controller", etc. as well as hardware capable of executing software in association with appropriate software. Moreover, any entity described herein as functional block, may correspond to or be implemented as "one or more modules", "one or more devices", "one or more units", etc. When provided by a processor, the functions may be provided by a single dedicated processor, by a single shared processor, or by a plurality of individual processors, some of which may be shared. Moreover, explicit use of the term "processor" or "controller" should not be construed to refer exclusively to hardware capable of executing software, and may implicitly include, without limitation, Digital Signal Processor (DSP) hardware, network processor, application specific integrated circuit (ASIC), field programmable gate array (FPGA), read only memory (ROM) for storing software, random access memory (RAM), and non-volatile storage. Other hardware, conventional and/or custom, may also be included.

It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

Furthermore, the following claims are hereby incorporated into the Detailed Description, where each claim may stand on its own as a separate embodiment. While each claim may stand on its own as a separate embodiment, it is to be noted that - although a dependent claim may refer in the claims to a specific combination with one or more other claims - other examples may also include a combination of the dependent claim with the subject matter of each other dependent claim. Such combinations are proposed herein unless it is stated that a specific combination is not intended. Furthermore, it is intended to include also features of a claim to any other independent claim even if this claim is not directly made dependent to the independent claim.

It is further to be noted that methods disclosed in the specification or in the claims may be implemented by a device having means for performing each of the respective steps of these methods.

Further, it is to be understood that the disclosure of multiple steps or functions disclosed in the specification or claims may not be construed as to be within the specific order. Therefore, the disclosure of multiple steps or functions will not limit these to a particular order unless such steps or functions are not interchangeable for technical reasons. Furthermore, in some examples a single step may include or may be broken into multiple sub steps. Such sub steps may be included and part of the disclosure of this single step unless explicitly excluded.

## Claims

1.  Method (200) for converting a signal (308) from analog to digital domain or vice versa, the method comprising:

    providing (210) a first and at least one second version (112-1; 112-2; 312-1; 312-2) of the signal, wherein the first and the second signal version (112-1; 112-2; 312-1; 312-2) differ by a predetermined phase difference;

converting (220) the first and the at least one second signal version (112-1; 112-2; 312-1; 312-2) from analog to digital domain or vice versa to generate a first and at least one second converted signal version (122-1; 122-2; 322-1; 322-2);

rotating (230) a phase of at least one of the first and the second converted signal (122-1; 122-2; 322-1; 322-2) to generate a first and at least one second phase-rotated converted signal (132-1; 132-2; 332-1; 332-2), wherein a difference of phase rotation between the first and the second converted signal corresponds to the predetermined phase difference; and

combining (240) the first and the at least one second phase-rotated converted signal (132-1; 132-2; 332-1; 332-2).

2. The method (200) of claim 1, wherein providing (210) the first and the at least one second signal version comprises applying a predetermined phase shift to at least one version of the signal to generate at least one phase shifted signal version among the first and at least one second signal version.

3. The method (200) of claim 2, wherein rotating (230) the phase of at least one of the first and the second converted signal comprises applying the inverse predetermined phase shift to at least one phase shifted converted signal to generate at least one de-rotated converted signal.

4. The method (200) of claim 2, wherein the applying at least one predetermined phase shift is performed in the analog domain or in the digital signal domain.

5. The method (200) of claim 1, wherein converting (220) the first and the at least one second signal version comprises converting the first signal version with a first signal converter (320-1; 620-1) and converting the at least one second signal version with at least one second signal converter (320-2; 620-2).

6. The method (200) of claim 5, wherein the first signal converter is a first Analog-to-Digital Converter (320-1) or a first Digital-to-Analog Converter (620-1) and wherein the at least one second signal converter is at least one second Analog-to-Digital Converter (320-2) or at least one second Digital-to-Analog Converter (620-2).

7. The method (200) of claim 1, wherein providing (210) the first and the at least one second version of the signal comprises providing an analog signal (708) comprising a baseband signal component and a carrier signal component, the method comprising:

converting a portion of the analog signal (708) corresponding to one cycle of the carrier signal component to the digital domain by generating a first digital signal sample (d(1)) of the analog signal at a first sampling instant within the cycle and generating at least a second digital signal sample (d(2)) of the analog signal at at least a second sampling instant within the cycle;

rotating a phase of at least one of the first and the second digital signal sample (d(1); d(2)) to generate a first and at least one second de-rotated digital signal sample, wherein a difference of phase rotation between the first and the second digital signal sample corresponds to a phase progression of the carrier signal component between the first and the second sampling instant; and

combining the first and the at least one second de-rotated digital signal sample.

8. The method (200) of claim 7, wherein converting the portion of the analog signal (708) comprises generating the first digital signal sample (d(1)) and the at least one second digital signal sample (d(2)) at evenly distributed sampling instants within the cycle.

9. The method (200) of claim 7, wherein a duration of one cycle of the carrier signal component is an integer multiple of a time difference between the first and second sampling time instants.

10. The method (200) of claim 7, wherein a frequency of the carrier signal component is in the range from 50 to 200 MHz.

11. The method (200) of claim 7, wherein a bandwidth of the baseband signal component is less than ¼ of a frequency of the carrier signal component.

12. The method (200) of claim 1, wherein providing (210) the first and the at least one second signal version comprises providing a digital signal (908) comprising a digital baseband signal component and a digital carrier signal component, wherein a first and at least one subsequent second sample of the digital signal differ by a predetermined phase difference,

wherein converting (220) the first and the at least one subsequent second sample comprises converting the digital signal (908) to the analog signal domain to generate an analog signal (922) comprising an analog baseband signal component and an analog carrier signal component;

wherein rotating (230) the phase comprises mixing the analog signal (922) with the analog carrier signal component to obtain the analog baseband signal component (932);

wherein the method further comprises:

providing a first and at least one second version (932-1; 932-2) of the analog baseband signal component, wherein the first and the second version differ by a predetermined phase difference, and combining the first and the at least one second version of the analog baseband signal component.

13. The method (200) of claim 12, wherein providing the first and the at least one second version of the analog baseband signal component (932-1; 932-2) comprises delaying at least one version of the analog baseband signal component to generate at least one delayed signal version among the first and at least one second version of the analog baseband signal component.

14. The method (200) of claim 13, wherein a delay of at least one delayed signal version relative to an undelayed version of the analog baseband signal component less than $\dfrac{1}{5*B}$, wherein B denotes a bandwidth of the baseband signal component.

15. The method (200) of claim 12, further comprising:

mixing the combined first and at least one second version of the analog baseband signal with an RF carrier signal.

16. An apparatus (100; 350; 650) for converting a signal from analog to digital domain or vice versa, the apparatus comprising:

signal provision (110; 310; 610) circuitry configured to provide a first and at least one second version of the signal, wherein the first and the second signal version differ by a predetermined phase difference; signal conversion circuitry (120; 320; 620) configured to convert the first and the at least one second signal version from analog to digital domain or vice versa to generate a first and at least one second converted signal version; phase rotation circuitry (130; 330; 630) configured to rotate a phase of at least one of the first and the second converted signal to generate a first and at least one second phase-rotated converted signal, wherein a difference of phase rotation between the first and the second converted signal corresponds to the predetermined phase difference; and signal combining circuitry (140; 340; 640) configured to combine the first and the at least one second phase-rotated converted signal.

17. A transmitter (950), comprising:

digital mixing circuitry (926) configured to mix a digital baseband signal (927) with digital carrier signal (928) to generate a digital IF signal (908), wherein a first and a subsequent second sample of the digital IF signal differ by a predetermined phase difference; a Digital-to-Analog Converter (920) configured to convert the digital IF signal to the analog domain to generate an analog IF signal (922) comprising an analog baseband signal component and an analog carrier signal component; analog mixing circuitry (930) configured to mix the analog signal (922) with the analog carrier signal component to obtain the analog baseband signal component; an analog delay network (940) configured to generate a first and at least one second version of the analog baseband signal component, wherein the first and the at least one second version are delayed relative to each other; and signal combining circuitry (944) configured to combine the first and the at least one second version of the analog baseband signal component.

18. The transmitter (950) of claim 18, wherein a frequency of the digital carrier signal (928) is in the range from 50 to 200 MHz and wherein a bandwidth of the digital baseband signal is lower than the frequency of the digital carrier signal (928).

19. The transmitter (950) of claim 18, wherein a delay of at least one delayed signal version relative to the undelayed analog baseband signal component is less than $\dfrac{1}{5*B}$, wherein B denotes a bandwidth of the baseband signal.

20. The transmitter of claim 18, further comprising:

analog mixing circuitry configured to mix an analog RF carrier signal with the combined first and at least one second version of the analog baseband signal component, wherein a frequency of the analog RF carrier signal is larger than a frequency of the digital carrier signal (928).

FIG. 1

# FIG. 2

_200_

providing a first and at least one second version of the signal,
wherein the first and the second signal version
differ by a predetermined phase difference ⟶ 210

converting the first and the at least one second signal
version from analog to digital domain or vice versa to generate
a first and at least one second converted signal version ⟶ 220

rotating a phase of at least one of the first and the second
converted signal to generate a first and at least one second
phase-rotated converted signal, wherein a difference of phase
rotation between the first and the second converted signal
corresponds to the predetermined phase difference ⟶ 230

combining the first and the at least one second
phase-rotated converted signal. ⟶ 240

# FIG. 3A

Zero IF receiver

_300_

Example:
RF signal at 2GHz
LO:2GHz

# FIG. 3B

_350_

FIG. 3C

360

302 RF_sig

302-0

302-1

302-n

306-0

306-1

306-n

Rotation (p0)  310-0

Rotation (p1)  310-n

Rotation (pn)

306 LO

312-0

312-1

312-n

ADC 320-0

ADC 320-1

ADC 320-n

322-0

322-1

322-n

Rotation (-p0) 330-0

Rotation (-p1) 330-1

Rotation (-pn) 330-n

340

+

# FIG. 4A

# FIG. 4B

# FIG. 4C

Error Plane

-120 degree

error2

Rotated error 2

Error sum

error1

# FIG. 5

## FIG. 6A

Zero IF transmitter

600

Example:
RF signal at 2GHz
LO:2GHz

## FIG. 6B

650

# FIG. 6C

660

608 IQ

610-0 Rotation (p0)
610-1 Rotation (p1)
610-n Rotation (pn)

608-1
608-n

620-0 DAC
620-1 DAC
620-n DAC

622-0
622-1
622-n

630-0 Rotation (-p0)
630-1 Rotation (-p1)
630-n Rotation (-pn)

632-0
632-n

RF_sig

LO

EP 3 306 820 A1

# FIG. 7A

IF receiver

700

RF_sig — 702 — 704 ✳ — I_IF — 720 ADC — 722 — 725 FPGA ✳ — 725

706 — LO1 — Q_IF — 708 — LO2

Example:
RF signal at 2GHz
LO1:-1.9GHz
LO2:-0.1GHz

# FIG. 7B

750

RF_sig — 702 — 704 ✳ — I_IF — 720 ADC — 722 — 725' FPGA

Q_IF — 708 — LO1

d(n) ··· d(2) d(1)

⇩ — 730

d(x+1) — d(1) → 730-1 — 732-1
d(x+2) — d(2) → 730-2 — + → IQ_BB
⋮ — ⋮ — 740
d(2x) — d(x) → 730-x — 732-x

Example:
RF signal at 2GHz
LO1:-1.9GHz
x=3
Sampling rate of d(n):300MHz

FIG. 8

# FIG. 9A

IF transmitter

Example:
RF signal at 2GHz
LO1:1.9GHz
LO2:0.1GHz

# FIG. 9B

Example:
RF signal at 2GHz
LO1:0.1GHz
LO2:2GHz

D1,..Dn are delays.

# FIG. 10A

# FIG. 10B

Digital Section

Analog front-end

VGA

LPF

BPF        LNA        BPF

LO

Cos / Sin

350

ADC

RF

BB

I

Q

VGA

LPF

Europäisches
Patentamt

European
Patent Office

Office européen
des brevets

**EUROPEAN SEARCH REPORT**

Application Number

EP 16 30 6319

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | Saqib Subhan ET AL: "D/A Resolution Impact on a Poly-phase Multipath Transmitter", Proceedings PRORISC 2008, 1 January 2008 (2008-01-01), pages 272-278, XP055036949, Retrieved from the Internet: URL:http://doc.utwente.nl/65347/1/Suban_ProRISC_2008.pdf [retrieved on 2012-08-31] * sections III B,C; section IV A; figures 5-7 * | 1-20 | INV.<br>H03M1/06<br>H04B1/04<br>H04B1/00<br><br>ADD.<br>H03M1/66<br>H03M1/12 |
| A | KLUMPERINK E A M ET AL: "Distortion Cancellation by Polyphase Multipath Circuits", IEEE TRANSACTIONS ON CIRCUITS AND SYSTEMS PART I: REGULAR PAPERS, IEEE SERVICE CENTER, NEW YORK, NY, US, vol. 52, no. 9, 1 September 2005 (2005-09-01), pages 1785-1794, XP011139054, ISSN: 1057-7122, DOI: 10.1109/TCSI.2005.852020 * section II G * | 1-20 | |
| X | US 6 650 264 B1 (CHAN BRIAN P LUM SHUE [US] ET AL) 18 November 2003 (2003-11-18) * column 5, line 19 - column 6, line 32; figures 5,6 * * column 7, lines 24-32 * | 1-7,9,16 | TECHNICAL FIELDS SEARCHED (IPC)<br><br>H03M<br>H04B |

The present search report has been drawn up for all claims

| Place of search | Date of completion of the search | Examiner |
|---|---|---|
| The Hague | 15 March 2017 | Galardi, Leonardo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

                                

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 16 30 6319

This annex lists the patent family members relating to the patent documents cited in the above-mentioned European search report.
The members are as contained in the European Patent Office EDP file on
The European Patent Office is in no way liable for these particulars which are merely given for the purpose of information.

15-03-2017

| Patent document cited in search report | | Publication date | Patent family member(s) | Publication date |
|---|---|---|---|---|
| US 6650264 | B1 | 18-11-2003 | NONE | |

For more details about this annex : see Official Journal of the European Patent Office, No. 12/82

EPO FORM P0459